# EUROPEAN PATENT SPECIFICATION

(11) **EP 2 973 736 B1**
(45) Date of publication and mention of the grant of the patent: **26.01.2022**
(21) Application number: 14768368.4
(22) Date of filing: 14.03.2014
(51) Int. Cl.: H01L 31/04, H01L 31/0224, H01L 31/18, G06F 3/041, C01B 21/082

(54) **NITROGEN-CONTAINING TRANSPARENT CONDUCTIVE OXIDE CAP LAYER COMPOSITION**
STICKSTOFFHALTIGE ZUSAMMENSETZUNG AUS EINER TRANSPARENTEN LEITFÄHIGEN OXIDKAPPENSCHICHT
COMPOSITION DE COUCHE DE COIFFE D'OXYDE CONDUCTEUR TRANSPARENT CONTENANT DE L'AZOTE

(30) Priority: 15.03.2013 US 201361789018 P
(43) Date of publication of application: 20.01.2016
(73) Proprietor: Arkema, Inc., King of Prussia, PA 19406 (US)
(72) Inventor: KOROTKOV, Roman Y., Kintg of Prussia, Pennsylvania 19406 (US); REILLY, Jack J., Blue Bell, Pennsylvania 19422 (US)
(74) Representative: Bandpay & Greuter
(86) International application number: PCT/US2014/027400
(87) International publication number: WO 2014/152493

(56) References cited:
- WO-A2-2011/047186
- US-A1- 2008 110 498
- US-A1- 2008 110 498
- US-A1- 2010 109 058
- US-A1- 2010 109 058
- US-A1- 2012 040 494

## Description

### FIELD OF THE INVENTION

This invention is directed to a composition, sometimes referred to as a transparent conductive oxide ("TCO") cap composition or TCO cap layer, that can be applied to a doped zinc oxide-coated glass substrate using a chemical vapor deposition ("CVD") process. The capping composition is of the type comprising at least nitrogen ("N"), oxygen ("O"), and at least two different metal elements, where at least one of the two metal elements is a Group IIIA element of the Periodic Table. This invention also is directed to a multilayered device having a glass substrate, a doped zinc oxide ("doped ZnO" or "DZO") layer, and the novel nitrogen containing TCO capping compositions described herein.

### BACKGROUND OF THE INVENTION

There are many applications and devices that require conductive and transparent coatings on substrates. Document US 2008/0110498 A1 discloses a photovoltaic cell comprising a transparent conductive layer, a first conductive layer and a nitrogen containing metal layer. The transparent conductive layer is a transparent conductive oxide such as tin oxide or tin oxide doped with fluorine and is covered by a capping layer made of materials such as silicon dioxide, dialuminum trioxide, titanium dioxide and diboron trioxide.

**A** doped zinc oxide ("doped ZnO" or "DZO") transparent conductive oxide layer is a prime candidate for multiple optoelectronic and architectural applications, including use in solar panel devices, photovoltaic devices, filters, touch screens, and displays. DZO is known to possesses very low resistivity (10⁻⁴ Ωcm), high electron mobility (5-67 cm²/Vs and concentration (1-20×10²⁰ cm⁻³), as well as low plasma wavelength, but not the thermal resistance, chemical resistance, and/or scratch resistance, or smoothness needed for certain applications. Low plasma wavelength paves the way for DZO in architectural applications, such as solar controlled coatings, filters, touch screens, and displays, but still lacks the desired properties mentioned above. Good electrical properties allow the utilization of the DZO as an electrode in photovoltaic devices ("PV"). Descriptions of DZO and its applications are provided in U.S. Patent Nos. 7,732,013; 8,163,342; 7,989,024, the disclosures of which are incorporated herein in their entireties.

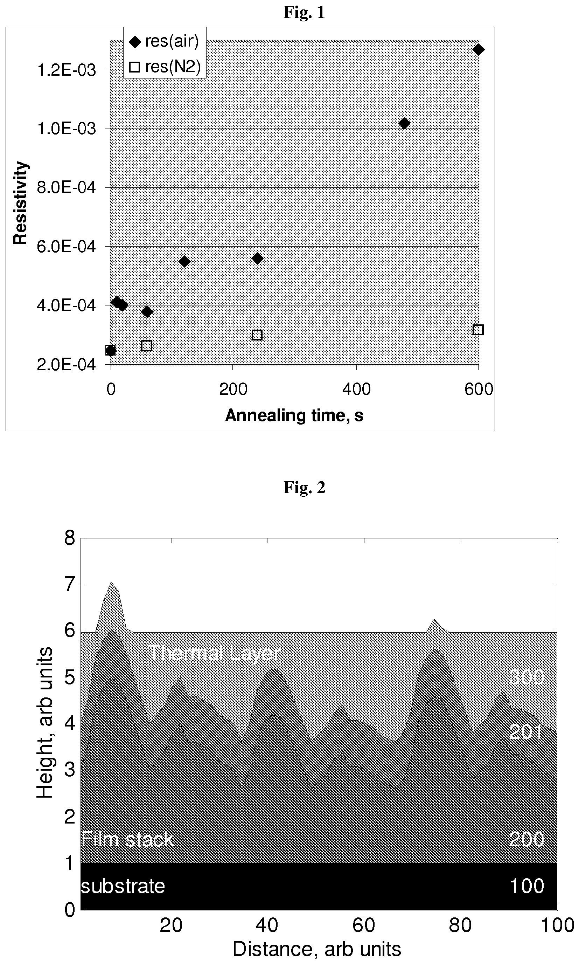

DZO displays degradation of electrical properties when exposed to higher temperatures in oxygen (O₂) containing environments and also sometimes in inert environments. Degradation refers to an increase of the resistivity as a function of ambient atmosphere, temperature and exposure time. For example, the DZO layer resistivity for a 600 nm thick layer increases by a factor of 6 when exposed to air at 500 °C (Fig. 1) for 10 minutes. In addition, the resistivity is increased by a factor of 1.5 when DZO coating is exposed to nitrogen gas at 500 °C over the same exposure time.

For most useful applications, the thickness of the conductive DZO layer is less than 600 nm, usually in the range of 100-270 nm, so that sheet resistances of 10-50 Ω/sq are achieved. For thinner DZO layers, degradation of resistivity when exposed to high temperatures is faster due to faster diffusivity of species into doped ZnO. For example, for 110 nm thick doped ZnO film, resistivity of the film increases by factors of 10 and 41, when the films are annealed in air at 500°C (5min) and 550 °C (10 min), respectively (Table 3). Therefore, development of the protective capping layer technology is important for doped ZnO.

Known capping layers for DZO include SiO₂, TiO₂, Al₂O₃, B₂O₃ (U.S. 2005/0257824), SnO₂ (U.S. 2011/0139237), SnO₂, and TiO₂ (U.S. 2012/0107554), SnO₂ (U.S. 2008/0128022). These materials belong to a class of transparent dielectric oxides. Except for doped SnO₂, these materials are insulators and as such, possess high resistivity. For effective operation of the semiconductor stack within photovoltaic device ("PV"), a charge transfer from the electrode, doped ZnO, preferably should be substantially unimpeded by the capping layer. Therefore, due to their inherent electrical contact blocking nature, the thickness of these known oxide dielectric materials is limited. Thin layers, however, due to their amorphous/polycrystalline nature, typically provide a poor oxygen protection barrier. Such materials may work well for doped ZnO coatings deposited by sputtering techniques at low temperature and/or pressure. As deposited, DZO layers have poor crystallinity and low mobility that leads to high resistivity. The electron concentrations, mobility and resistivities in these DZO films are typically restricted to 5-7×10²⁰cm⁻³, 5-20 cm²/Vs and >6×10⁻⁴ Ohm cm, respectively (U.S. 2012/0107554, U.S. 2008/0128022). Thermal annealing at high temperature greater than 400°C usually helps to improve the overall crystal quality of DZO and consequently maximizes carrier mobility, where an oxide dielectric capping layer serves as a porous membrane for oxygen diffusion in and out of the material stack (D. M. Smyth, Defect Chemistry of Metal Oxides, New York Oxford, Oxford University Press, 2000). Thermal annealing of the low quality sputtered oxides for improving their electrical properties is used for In₂O₃:Sn activation.

Another approach uses different oxygen barrier layers, such as Ni metal, Ni/Ni coatings (T. Chen, APL 100 013310, 2012) and SiN barrier layers (F. Ruske, J. Applied Phys. 107, 013708, 2010). Nickel capping layers often have very low optical transmission due to a large extinction coefficient and require precise control of the thickness at the percolation barrier. SiₓN_{y} layers were effective in improving electrical properties of low electron concentration (6×10²⁰ cm⁻³) DZO layers and require sputtering as the main deposition technique for SiₓN_{y}. For example, mobility of 67 cm²/Vs was demonstrated in glass/AZO/SiₓN_{y} construction after high temperature annealing (F. Ruske et al., Improved Electrical Transport in Al-doped Zinc Oxide by Thermal Treatment, Journal of Applied Physics, 107, 013708 (2010).

Deterioration of electrical properties as a function of annealing temperature is a known disadvantage when using DZO for architectural and PV applications. During glass tempering process, the DZO substrates are often reheated above the glass transition temperature ~ 650 °C in air. Currently, DZO stacks are deposited and cooled in O₂-free environment. Introduction of DZO plus cap mutilayer stack may reduce the cost of providing an O₂-free environment during deposition and cool down cycles.

As far as PV device process is concerned, as part of solar cell deposition process, DZO undergoes multiple temperature cycle steps (500-650°C). In each of these cycles, the ambient environment may contain O-rich species as well as other DZO harmful environments (A. Luque et al. Handbook of Photovoltaic Science and Engineering 2012).

As compared to fluorine-doped SnO₂, DZO possesses poor scratch resistance and is easily etched by conventional acids. Also, a DZO layer may or may not have an optimum surface morphology, which for some applications is highly smooth or conversely very rough. Thus, there is a need to improve the properties of DZO transparent conductive oxide layers.

### SUMMARY OF THE INVENTION

**The above problems are solved by a photoelectric device according to claim 1 and a nitrogen-containing TCO cap composition according to claim 5.** The present disclosure also relates to compositions, including transparent conductive oxide ("TCO") cap compositions or TCO cap layers, that can be applied in a continuous or discontinuous fashion to the surface of a substrate by deposition or other process. In one aspect of the disclosure, a substrate is a glass substrate. The cap composition or cap layer may or may not be in direct contact with the TCO layer. In one aspect of the disclosure, the cap composition or cap layer is in direct contact with a DZO transparent conductive oxide composition or layer. In another aspect of the disclosure, the cap composition or cap layer is not in direct contact with a DZO transparent conductive oxide composition or layer. There may be an additional composition(s) and/or layer(s) positioned on either face of the capping compositions or layers. In one aspect of the disclosure, the TCO cap compositions/layers of the invention are nitrogen-containing compositions that comprise, consist essentially of, or consist of, nitrogen, oxygen, and at least two different metal elements, where at least one of the metal elements is chosen from Group IIIA of the Periodic Table (including B, Al, Ga, In, and Tl).

The TCO cap compositions of the invention are compositions recited in claim 5. They consist of, Zn_{w}OₓN_{y}Y_{z}, where w, x, y and z are atomic percent concentration ranges for each element in the composition, and where the sum of w+x+y+z equals 100-χ, such that χ represents atomic percent of unintentionally incorporated impurities, such as carbon and sulfur. The total concentration of unintentionally incorporated impurity is usually 10 atomic percent or less, and preferably less than 10 atomic percent. Y is chosen from the Group IIIA elements of the Periodic Table (also called Group 13) (e.g., B, Al, Ga, and In), preferably B, Al, and/or Ga, more preferably Ga.

In another aspect of the disclosure, the TCO cap compositions/layers comprise, consist essentially of, or consist of, N_{y}Y_{z}, and optionally Zn_{w}O_{x.} where w, x, y and z are atomic percent concentration ranges for each element in the composition, and where the sum of w+x+y+z equals 100-χ, such that χ represents atomic percent of unintentionally incorporated impurities, such as carbon and sulfur. The total concentration of unintentionally incorporated impurity is usually 10 atomic percent or less, and preferably less than 10 atomic percent. Y is chosen from the Group IIIA elements of the Periodic Table (also called Group 13) (e.g., B, Al, Ga, and In), preferably B, Al, and/or Ga, more preferably Ga.

The description mentions methods for manufacturing such TCO cap compositions/layers/coatings. The present disclosure also relates to architectural coatings incorporating such multilayer compositions or multilayer stacks that undergo annealing and tempering.

There is also described as an example a deposition technique for Zn_{w}OₓN_{y}Y_{z} materials. Deposition methods are not limited to chemical vapor deposition but also may include other techniques that are known to those skilled in the art, such as, for example, sputtering, spray pyrolysis, pulse laser deposition and others. The APCVD (atmospheric pressure chemical vapor deposition) apparatus used herein is similar to that described in U.S. patent No. 6,268,019

This invention also relates to photovoltaic devices comprising glass substrates and the multilayer coatings and TCO capping compositions/layers described herein.

There is described as an example a process of online or off-line production of DZO plus cap process in the open air environment as a way to produce electrodes for organic light emitting diodes (OLEDS), touch screens, and displays. Using an online process, each coating layer may be deposited in sequential fashion as the glass substrate is being produced.

The compositions of the invention provide thermally resistant, chemically resistant, and/or scratch resistant contiguous or incontiguous surfaces or layers for transparent conductive oxide films (TCO) comprising doped zinc oxide.

### BRIEF DESCRIPTION OF THE DRAWINGS

FIG. 1 Dependences of the resistivities for DZO samples annealed in air (filled diamond) and nitrogen (open squares) as a function of time at 550°C;
Fig. 2 Schematic cross-section view of a substrate carrying a coating stack;
FIG. 3 XPS depth profile for sample #4 (Table 2);
FIG. 4 Optical transmittance of glass/Zn_{w}OₓN_{y} and glass/ Zn_{w}OₓN_{y}Ga_{z} film stack discussed in examples.
Fig. 5 Optical transmittance (T) and reflectance (R ) for the DZO sample # 1 - no capping layer (Table 2). Light black T and R curves are for the as-grown DZO. Bold black T and R curves are for 500 °C annealed DZO for 5 minutes. Bold white T and R curves are for 550°C annealed samples.
Fig. 6 a-b Optical transmittance (T) and reflectance (R ) for the DZO sample # 4 and 5: glass/DZO/ Zn_{w}OₓN_{y}Ga_{z}. Light black T and R curves are for the as-grown DZO. Bold black T and R curves are for 500 °C annealed DZO for 5 minutes. Bold white T and R curves are for 550°C annealed DZO for 10 minutes.

### DETAILED DESCRIPTION OF THE INVENTION

As used herein, "doped ZnO" or "DZO" refers to zinc and oxygen containing oxide film(s), layer(s), or composition(s),that may be combined, alloyed or doped with other elements. The as-obtained doped ZnO coatings are referred to herein as alloys or mixtures. Examples of possible dopants (elements combined into coating layers) include but are not limited to B, Al, Ga and In, as well as Sn, W, Ta, Nb, and halogens. A combination of these elements into a coating provides desired optoelectronic properties.

The invention is directed to a novel capping composition or layer that improves the overall properties of TCOs such as DZO. In this invention, a new compound, material, alloy, or mixture has been discovered, namely, Zn_{w}OₓN_{y}Y_{z}, where w, x, y, z are atomic percents of the elements zinc (Zn), oxygen (O), nitrogen (N), and Y, in the compound, where w is from 20 to 80, x is from 10 to 50, y is from 10 to 50, z is from 10 to 50, such that the sum of all concentrations (w + x + y + z + χ) is equal to 100 %, and where χ represents a total sum of concentrations of unintentionally incorporated impurities. Typically the amount of unintentionally incorporated impurities will be less than about less than 10 atomic percent, preferably less than about 5.5 atomic percent, more preferably less than about 5 atomic percent, more preferably less than about 3 atomic percent, more preferably less than 1 atomic percent.

In one embodiment, Y represents at least one element selected from the group consisting of Group IIIA elements. In one embodiment, Y represents at least one element selected from the group consisting of B, Al, Ga, In and Tl, preferably Ga.

In another embodiment, Y represents at least one element selected from the group consisting of B, Al, Ga, In, Tl, Sn, W, Ta, and Nb.

In another embodiment, Y represents at least one element selected from the group consisting of B, Al, Ga, In, Tl, Sn, W, Ta, Nb, F, Cl, Br, I, and At.

Also disclosed herein is a TCO capping composition or layer having at least N, Zn and Y, where O is optional.

Also disclosed herein are binary capping compositions or layers having at least N and at least Y, where zinc and/or oxygen are optional.

Atomic percents are defined in a way that normalized fractions are obtained: w + x + y + z = 100, assuming that unintentional dopant concentration is equal to zero. For example, some of the binary compounds, such as Zn₃N₂, will have w = 60 %, x = 0, y = 40 % and z = 0. GaN will have w = 0, x = 0,y = 50 % and z = 50%. The specific concentrations will vary depending upon the application.

According to the invention, w is from about 20 to 80 %, x is from about 10 to 50 %, y is from about 10 to 50%, and z is from about 10 to 50%.

The invention also is directed an embodiment where the capping layer composition comprises Zn_{w}OₓN_{y}Ga_{z}

In another embodiment, Zn_{w}OₓN_{y}Ga_{z} capping layers are preferred.

An exemplary stack configuration/diagram is shown in Fig. 2.

Substrates (100) of various sizes and thickness can be used in the implementation of the present invention. The thickness of the glass can vary from ultra-thin glass 0.01 mm to 20 mm thick glass panels. Other substrates include but are not limited to metals, plastics, and polymers.

The DZO configuration (200) and (201) may comprise multiple layers, such as for example, undercoat layers (that may or may not scatter light or help improve transmission or color suppression) and additional TCO compositions/layers (see, e.g., WO2011/005639 A1).

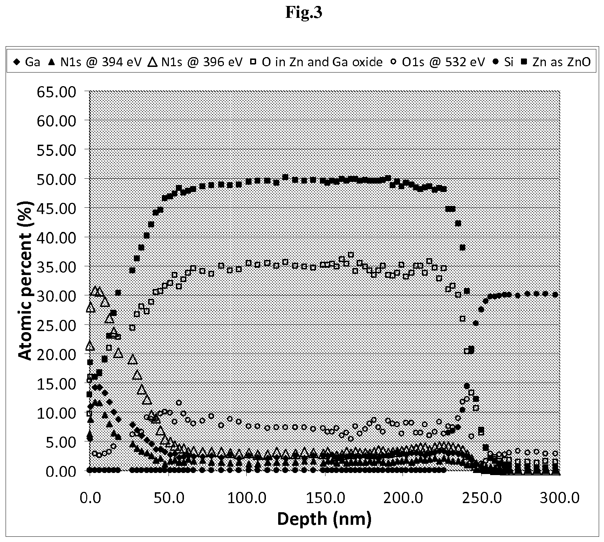

The capping layer (300) may or may not consist of a single layer. A depth profile of one of the studied stacks suggests a complicated compositional structure of the capping layer as a function distance within a coating (Fig. 3). It is visible in this figure that within the thickness of the capping layer, the N Is (396 eV) atomic concentration varies from 10 at the surface to 27 % in the middle of the capping layer thickness.

With respect to the TCO cap compositions/layers of the present invention, the inventors have unexpectedly discovered that an increased amount of nitrogen can be incorporated into ZnO without deleterious impact on transparency by the addition of gallium into the composition. In one embodiment, a Zn_{w}OₓN_{y}Ga_{z} alloy system is preferred, where the presence of Zn-N and Ga-N helps reduce oxygen diffusion through the DZO layer. DZO films considered here are of high quality (mobility 15-50 cm²/Vs, carrier concentration 5-20×10²⁰ cm⁻³ and resistivity 1-6×10⁻⁴ Ohm cm) These layers are deposited at high temperature (greater than 400°C) and are highly textured with preferred orientation of (0002).

The incorporation of nitrogen in ZnO structures at 500°C requires modification of the deposition parameters. In addition, the band gap of the zinc nitride is very small (< 1 eV) that adds considerable absorption to the visible part of the spectrum. Samples of 120 nm thick Zn_{w}OₓN_{y}Ga_{z} were deposited by CVD. They were dark to the naked eye suggesting lack of oxygen and potential carbon and Zn metal incorporation. XPS measurement on the film confirmed this theory - up to 4.4 atomic percent of carbon was detected on the surface of these layers. The Zn/O atomic ratio increased from 1 for the normal DZO to 1.5 in nitrogen enriched DZO.

Zinc nitride (Zn₃N₂) is a known non-transparent/opaque conductor. The inventors discovered, however, that the transparency window of this material can be expanded towards visible with oxygen. The deposition of the zinc nitride is a thermodynamically controlled process. Small heat of formation energies of Zn_{w}N_{z} compared to high negative values for ZnO tends to reduce incorporation of nitrogen within Zn_{w}O_{y}N_{z} system by CVD at high temperatures (>400°C). It was further discovered that a larger amount of nitrogen can be incorporated into ZnO without harmful effect on transparency by adding small amounts of Ga. Without being bound to any theory, it may be that highly negative heat of formation of GaN allows larger incorporation of nitrogen within the Zn_{w}OₓN_{y}Ga_{z} system.

A combined DZO stack+cap as described herein has been developed by Arkema Inc. The TCO capping composition or layer comprises, consists essentially of, or consists of Zn_{w}OₓN_{y}Ga_{z} compound, alloy, or mixture. It possesses several key properties, such as improved thermal, chemical, and scratch resistances. It also has been shown to planarize DZO layers, meaning improved surface smoothness. In addition, the thermal performance of the DZO/cap stack is improved as compared to an unmodified/uncapped DZO stack coating.

### EXAMPLES

### Example 1: Deposition of Zn_{w}O_{y}N_{z} films. (Example 1 is a comparative example not part of the invention)

A gas mixture of 0.31 mmol/min of ZnMe₂-MeTHF in 10 sLpm of nitrogen carrier gas was fed into a primary feed tube at 70°C. A preheated (80°C) secondary feed containing 5.5 sLpm of NH₃ was co-fed with the primary flow. The substrate used for the deposition was borosilicate glass with the thickness of 0.7 mm. The substrate was heated on resistively heated nickel block set at 500°C. The deposition time for these films was 120 seconds in a static mode, and resulting Zn_{w}OₓN_{y} films had thickness of 90 nm, for a deposition rate of 0.75 nm/s. The measured atomic percents of the elements are listed in Table 1. Nitrogen was incorporated at 2.6 atomic percent in these film as measured by x-ray photoelectron spectroscopy (XPS) which is a known tool for the skilled in the art. The atomic percents were w = 55 %, x = 37 %, y = 03 % and z = 0%, with the remainder being unintentional impurities.

### Example 2: Deposition of Zn_{w}OₓN_{y}Ga_{z} films.

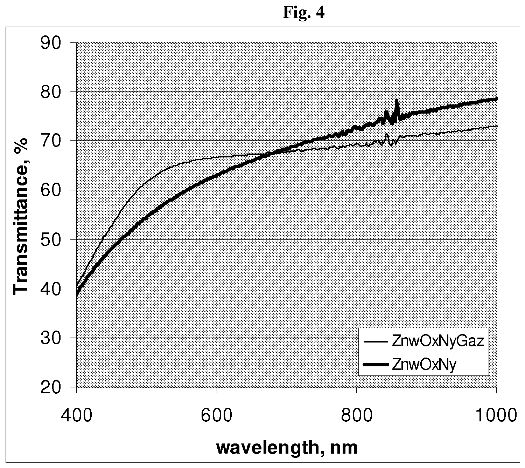

A gas mixture of 0.31 mmol/min of ZnMe₂-MeTHF in 10 sLpm of nitrogen carrier gas was mixed with 50 sccm of Me₂Gacac stream in a primary feed tube heated at 80°C. The gallium source was kept in a bubbler at 35°C. Preheated to 80°C secondary feed containing 5.5 sLpm of NH₃ was co-fed with the primary flow. The substrate used for the deposition was borosilicate glass with the thickness of 0.7 mm. The substrate was heated on resistively heated nickel block set at 500°C. The deposition time for these films was 120 seconds in a static mode, and resulting Zn_{w}OₓN_{y}Ga_{z} film had thickness of 80 nm, for a deposition rate of 0.67 nm/s. The measured atomic concentrations of the elements are listed in Table 1. Addition of gallium precursor in the vapor stream helped to improve incorporation of nitrogen. The total nitrogen atomic concentration was 18.3 % as determined by XPS. In addition, 8.2 atomic % of Gallium was found in this film. The atomic percents were w = 45 %, x = 26 %, y = 18 % and z = 8 % with χ = 3 %. Both Zn_{w}OₓN_{y} and Zn_{w}OₓN_{y}Ga_{z} films showed good optical transmittance (Fig. 4). Optical transmittance was measured using Perkin-Elmer lambda 900 spectrophotometer using air as a reference signal.

**Table 1. Atomic percents of the elements at the surfaces of each sample.**

| Compound/XPS | Zn_{w}OₓN_{y} | Zn_{w}OₓN_{y}Ga_{z} |
|---|---|---|
| Zn2p | 55.1 | 45.0 |
| O1s | 37.1 | 25.8 |
| C1s | 4.4 | 2.7 |
| N1s | 2.6 | 18.3 |
| S2p | 0.8 | 0.0 |
| Ga 2p | 0.0 | 8.2 |

### Example 3: Deposition of glass/160 nmDZO/Zn_{w}OₓN_{y}Ga_{z} stack.

A gas mixture of 1.23 mmol/min of ZnMe₂-MeTHF in 11 sLpm of nitrogen carrier gas was fed into a primary feed tube at 80°C. The dopant was introduced into the primary feed tube from a stainless steel bubbler. The bubbler contained GaMe₂acac at 35°C. Ga-precursor was picked up by preheated to 40°C nitrogen with a flow rate of 500 sccm. The oxidants were introduced into a secondary feed tube through two stainless steel bubblers. The first and second bubblers contained H₂O and 2-propanol at 60 and 65 °C, respectively. H₂O was picked by preheated to 65 °C nitrogen with the flow rate of 400 sccm. 2-Propanol was picked up preheated to 70 °C nitrogen with the flow rate of 560 sccm. The secondary feeds were co-fed with the primary flow inside a mixing chamber. The mixing chamber was 1 ¼ inch in length, corresponding to a mixing time of 250 msec between the primary and secondary feed streams. The substrate used for the deposition was borosilicate glass with the thickness of 0.7 mm. The substrate was heated on resistively heated nickel block set at 500°C. The resulting ZnO films had thickness between 120 and 174 nm. The deposition of the 1^{st} layer (DZO) was followed by deposition of the capping layer. The thickness of the capping layers was varied (Table 2).

The capping layer was deposited as follows. A gas mixture of 0.31 mmol/min of ZnMe₂-MeTHF in 10 sLpm of nitrogen carrier gas was mixed with 50 sccm of Me₂Gacac stream in a primary feed tube heated at 70°C. The gallium source was kept in a bubbler at 35°C. Preheated to 70°C secondary feed containing 5.5 sLpm of NH₃ was co-fed with the primary flow. The deposition time for these films varied. Resulting Zn_{w}OₓN_{y}Ga_{z} film thicknesses were determined using spectroscopic ellipsometry (SE) measurements (Table 2). Characterization of the thin film stacks using SE is well known technique in the present art.

**Table 2 Properties of the capping layers glass/DZO/Zn_{w}OₓN_{y}Ga_{z} film stack.**

| # | Layer1, nm | Layer 2, nm | RMS, nm | Zₘₐₓ, nm | Grain size, nm |
|---|---|---|---|---|---|
| 1 | 123 | - | 7.9 | 86.5 | 50x50 |
| 2 | 116 | 19 | 4.3 | 44.1 | 55x65 |
| 3 | 170 | 42 | 5.0 | 40 | 45x50 |
| 4 | 174 | 41 | 7.0 | 54.7 | 70x70 |
| 5 | 170 | 56 | 15.0 | 96.6 | 65×100 |

The introduction of the capping layers reduced the roughness of the DZO coatings. The term 'roughness' here refers to the root mean square (RMS) roughness and maximum valley to peak values (Zₘₐₓ) as measured by Atomic Force Microscopy (AFM) using techniques known to those skilled in the art. The maximum reductions in RMS (46 %) and Zₘₐₓ (54 %) values were obtained for 24 and 42 nm thick Zn_{w}OₓN_{y}Ga_{z} capping layers, respectively.

To characterize electrical properties for as-grown and annealed samples, one skilled in the art uses optical spectroscopy. Again, the term 'as-grown' refers to DZO samples deposited as described by (U.S. patent Nos. 7,732,013, 8,163,342, 7,989,024, patents. The term "annealed' is used to describe thermal treatment of the as-grown samples. For example, the samples may be annealed in air, vacuum and nitrogen ambient at different annealing temperatures. It is further assumed that the annealing environment may include other gases known to the skilled professional.

The application of the spectroscopic technique to determining electrical properties of the coatings relies on a known relationship between a plasma wavelength and electron concentration (n), such as λₚ ~ n^{-1/2}. Here, the term plasma wavelength (λₚ) describes a point of intersection of refractive index and extinction coefficient and entire teachings of which are described herein by this reference (J. Pankove, Optical process in semiconductors and R. Y. Korotkov et al., Proc. of SPIE Vol. 7939 793919-1, 2011). Electron mobility and concentration are given by µ = 1.15/(m^{∗}Γ_{D}) and n=0.73×10²¹m^{∗}ε_{∞}(hc/λₚ)², where m^{∗} is an effective mass, Γ_{D} is an oscillator damping term, h is Planck's constant and c is velocity of light. Qualitatively, the presence of the plasma wavelength in the studied spectroscopic range is always accompanied by a strong reflection curve.

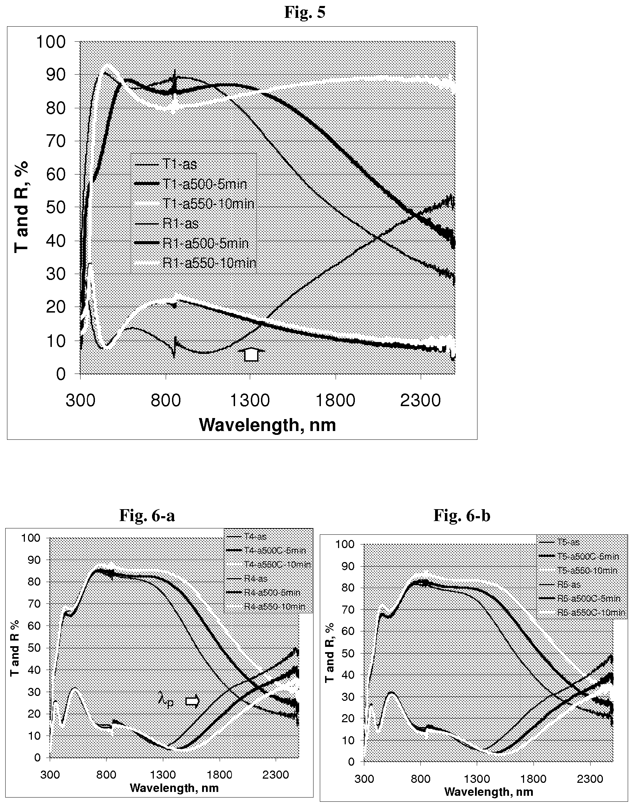

Reflection curves for the as-grown sample indicate λₚ =1.22 nm (Fig. 5 and Table 3 sample # 1). When the sample is annealed at 500°C for 5 minutes in air, the plasma wavelength is moved into a deep IR (λₚ = 3 µm) (Table 3). The value for the plasma wavelength increases further to 6.3 µm for the uncapped sample #1 annealed at 550 °C for 10 minuts. In this example plasma wavelength shifts from 1.22 for as-grown sample to 6.3 µm for annealed at 550 °C Samples with Zn_{w}OₓN_{y}Ga_{z} capping layers 41-56 nm thick showed improved optical properties (Fig. 6 a-b). Both samples showed only a small shift of the plasma wavelength towards IR. For example, plasma wavelength for the capped sample #4 increased from 1.16 to 1.3 when annealed at 500 °C for 5 minutes in the air ambient. To understand the affect of high temperature annealing on the properties of the DZO layers, electron concentration, mobility and resistivity were calculated using spectroscopic data presented in Fig. 6 a-b and optical models developed earlier (R. Y. Korotkov et al., Proc. of SPIE Vol. 7939 793919-1, 2011). These calculations indicated that resistivity of the 110 nm thick uncapped DZO (#1) increases by 10 and 41 times respectively for 500 °C (5 min) and 550 °C (10 minutes) annealing experiments (Table 3). However, when 40-56 nm cap is used the resistivity stays approximately constant and even decreases in some cases. For example, 174 nm thick sample (#4) with Zn_{w}OₓN_{y}Ga_{z} cap before annealing had resistivity of 5 × 10⁻⁴ Ωcm. When it was annealed at 500 °C (5 min) and 550 °C (10 minutes), resistivity changed to 4.95 and 4.16, respectively. Similar results were obtained for the capped sample # 5.

To understand the effect of the Zn_{w}OₓN_{y}Ga_{z} cap thickness on the electrical properties of the DZO, electrical properties for the sample with 19 nm thick cap were calculated, sample #2 (Table 3). As-grown sample #2 had resistivity of 3.1 × 10⁻⁴ Ωcm. When annealed to 500 °C (5 min) and 550 °C (10 min) in the ambient air, its resistivities increased to 3.95 and 17 × 10⁻⁴ Ωcm, respectively. The plasma wavelength shifted in the red from 1.15 to 3.2 µm, when annealed under the same conditions.

These results indicated that Zn_{w}OₓN_{y}Ga_{z} capping layers serve as good barrier layers during annealing of the DZO films in air ambient with the optimum thickness of 40-60 nm.

**Table 3 Variation of electrical properties: electron concentration, mobility and resistivity for the uncapped and Zn_{w}OₓN_{y}Ga_{z} capped doped ZnO layers. The values for the plasma wavelength, λₚ are also added for comparison. The calculations were based on reflection data presented in Fig. 6 a-b.**

| # | Cap nm | Annealing,C | Anealing time, min | λₚ, µm | µ, cm²/Vs | n × 10²⁰, cm⁻³ | ρ×10-4, Ωcm |
|---|---|---|---|---|---|---|---|
| 1as | 0 | As-grown | 0 | 1.22 | 26.5 | 9.3 | 2.56 |
| 1a1 | 0 | 500 | 5 | 3 | 16 | 1.5 | 26.3 |
| 1a2 | 0 | 550 | 10 | 6.3 | 16 | 0.37 | 105 |
| 2as | 19 | As-grown | 0 | 1.15 | 18 | 11.2 | 3.1 |
| 2a1 | 19 | 500 | 5 | 1.5 | 24 | 6.6 | 3.94 |
| 2a2 | 19 | 550 | 10 | 3.2 | 24 | 1.45 | 17.9 |
| 4as | 41 | As-grown | 0 | 1.16 | 16.6 | 7.53 | 5.01 |
| 4a1 | 41 | 500 | 5 | 1.3 | 19.2 | 6.56 | 4.95 |
| 4a2 | 41 | 550 | 10 | 1.42 | 26.6 | 5.63 | 4.16 |
| 5as | 56 | As-grown | 0 | 1.17 | 15.4 | 7.82 | 5.19 |
| 5a1 | 56 | 500 | 5 | 1.31 | 18.6 | 6.78 | 4.95 |
| 5a2 | 56 | 550 | 10 | 1.43 | 23 | 6.02 | 4.5 |

### Example 4

A series of acid sensitivity tests were performed on the coatings discussed in this invention using 10% by volume HCl solution. Each of the coatings glass/DZO

Zn_{w}OₓN_{y}Ga_{z} (capped, i.e., cap+DZO+glass substrate) and glass/DZO (uncapped, i.e,. DZO+glass substrate) were placed in this solution. All uncapped coatings were etched within seconds. In contrast, the thickness of capped DZO coatings was unchanged by the etching process within 2 minutes of acid exposure as verified by the SE studies.

As shown above, the capping layer compositions of the invention provide improved thermal resistance properties to the DZO stack, thereby helping to preserve the optical and electrical properties of the stack when it is subjected to annealing in different environments and at elevated temperatures. In addition, it also improves the chemical and scratch resistance properties.

The following detailed description of preferred embodiments is related to examples that are supported by the drawings. Skilled in the art scientist will recognize that presented drawings and examples have many alternatives that fall within the scope of this invention.

## Claims

1. A photoelectric device comprising a glass substrate (100); an undercoating film adjacent to the glass substrate; a doped zinc oxide transparent conductive oxide layer (200, 201) adjacent to the undercoating film; and a nitrogen-containing cap layer (300) adjacent to the doped zinc oxide transparent conductive layer, said cap layer comprising nitrogen, zinc and oxygen, wherein said nitrogen-containing cap layer comprises a mixture of Zn_{w}OₓN_{y}Y_{z}, where w, x, y, z are atomic percents of zinc, oxygen, nitrogen, and Y in the compound, where w is from 20 to 80, x is from 10 to 50, y is from 10 to 50, z is from 10 to 50, such that the sum of all concentrations (w + x + y + z + χ) is equal to 100, where χ represents a total sum of impurities in atomic percent and wherein Y represents one or more elements selected from the group consisting of B, Al, Ga, In, and Tl.

2. The photoelectric device of claim 1 wherein said nitrogen-containing cap layer comprises nitrogen, zinc, oxygen, and gallium.

3. The photoelectric device of claim 1 wherein Y is Ga.

4. The photoelectric device of claim 1 where χ is 10 atomic percent or less.

5. A nitrogen-containing TCO cap composition for covering a doped zinc oxide transparent conductive oxide layer (200, 201), consisting of Zn_{w}OₓN_{y}Y_{z}, where w, x, y, z are atomic percents of zinc, oxygen, nitrogen, and Y in the composition, where w is from 20 to 80, x is from 10 to 50, y is from 10 to 50, z is from 10 to 50, such that the sum of all concentrations (w + x + y + z + χ) is equal to 100, where χ represents a total sum of impurities in atomic percent and wherein Y represents one or more elements selected from the group consisting of B, Al, Ga, In, Tl, Sn, W, Ta, Nb, F, Cl, Br, I, and At.

6. The nitrogen-containing TCO cap composition of claim 5 wherein Y represents one or more elements selected from the group consisting of B, Al, Ga, In, Tl.

7. The nitrogen-containing TCO cap composition of claim 5 wherein Y is Ga.

8. The nitrogen-containing TCO cap composition of claim 5 where χ is 10 atomic percent or less.

9. The nitrogen-containing TCO cap composition of claim 5 which is a film or layer.

10. An organic light emitting diode comprising an electrode, wherein said electrode comprises the nitrogen-containing TCO cap composition of claim 5.

11. A touch screen comprising an electrode, wherein said electrode comprises the nitrogen-containing TCO cap composition of claim 5.

12. A display device comprising an electrode, wherein said electrode comprises the nitrogen-containing TCO cap composition of claim 5.

## Patentansprüche

1. Photoelektrische Vorrichtung, umfassend: ein Glas-Substrat (100); einen Unterschichtfilm benachbart zum Glas-Substrat; eine dotierte durchlässige leitende Zinkoxid-Oxidschicht (200, 201) benachbart zum Unterschichtfilm; und eine stickstoffhaltige Verkappungsschicht (300) benachbart zur dotierten durchlässigen leitenden Zinkoxidschicht, wobei die Verkappungsschicht Stickstoff, Zink und Sauerstoff umfasst, wobei die stickstoffhaltige Verkappungsschicht ein Gemisch von Zn_{w}OₓN_{y}Y_{z} umfasst, wobei w, x, y, z Atomprozente von Zink, Sauerstoff und Stickstoff und Y in der Verbindung sind, wobei w von 20 bis 80 ist, x von 10 bis 50 ist, y von 10 bis 50 ist, z von 10 bis 50 ist, derart dass die Summe aller Konzentrationen (w + x + y + z + χ) gleich 100 ist, wobei χ eine Gesamtsumme von Fremdatomen in Atomprozent darstellt, und wobei Y ein oder mehrere Elemente darstellt, die aus der Gruppe bestehend aus B, Al, Ga, In und Tl ausgewählt sind.

2. Photoelektrische Vorrichtung nach Anspruch 1, wobei die stickstoffhaltige Verkappungsschicht Stickstoff, Zink, Sauerstoff und Gallium umfasst.

3. Photoelektrische Vorrichtung nach Anspruch 1, wobei Y Ga ist.

4. Photoelektrische Vorrichtung nach Anspruch 1, wobei χ 10 Atomprozent oder weniger ist.

5. Stickstoffhaltige TCO-Verkappungszusammensetzung zum Abdecken einer dotierten durchlässigen leitenden Zinkoxid-Oxidschicht (200, 201), die aus Zn_{w}OₓN_{y}Y_{z} besteht, wobei w, x, y, z Atomprozente von Zink, Sauerstoff, Stickstoff und Y in der Verbindung sind, wobei w von 20 bis 80 ist, x von 10 bis 50 ist, y von 10 bis 50 ist, z von 10 bis 50 ist, derart dass die Summe aller Konzentrationen (w + x + y + z + χ) gleich 100 ist, wobei χ eine Gesamtsumme von Fremdatomen in Atomprozent darstellt, und wobei Y ein oder mehrere Elemente darstellt, die aus der Gruppe bestehend aus B, Al, Ga, In, Tl, Sn, W, Ta, Nb, F, Cl, Br, I und At ausgewählt sind.

6. Stickstoffhaltige TCO-Verkappungszusammensetzung nach Anspruch 5, wobei Y ein oder mehrere Elemente darstellt, die aus der Gruppe bestehend aus B, Al, Ga, In und Tl ausgewählt sind.

7. Stickstoffhaltige TCO-Verkappungszusammensetzung nach Anspruch 5, wobei Y Ga ist.

8. Stickstoffhaltige TCO-Verkappungszusammensetzung nach Anspruch 5, wobei χ 10 Atomprozent oder weniger ist.

9. Stickstoffhaltige TCO-Verkappungszusammensetzung nach Anspruch 5, die ein Film oder eine Schicht ist.

10. Organische Leuchtdiode, umfassend eine Elektrode, wobei die Elektrode die stickstoffhaltige TCO-Verkappungszusammensetzung nach Anspruch 5 umfasst.

11. Berührungsbildschirm, umfassend eine Elektrode, wobei die Elektrode die stickstoffhaltige TCO-Verkappungszusammensetzung nach Anspruch 5 umfasst.

12. Anzeigevorrichtung, umfassend eine Elektrode, wobei die Elektrode die stickstoffhaltige TCO-Verkappungszusammensetzung nach Anspruch 5 umfasst.

## Revendications

1. Dispositif photoélectrique comprenant un substrat en verre (100) ; un film de sous-couche adjacent au substrat en verre ; une couche d'oxyde conductrice transparente d'oxyde de zinc dopé (200, 201) adjacente au film de sous-couche ; et une couche de couverture contenant de l'azote (300) adjacente à la couche conductrice transparente d'oxyde de zinc dopé, ladite couche de couverture comprenant de l'azote, du zinc et de l'oxygène, dans lequel ladite couche de couverture contenant de l'azote comprend un mélange de Zn_{w}OₓN_{y}Y_{z}, où w, x, y, z sont des pourcentages atomiques de zinc, d'oxygène, d'azote et de Y dans le composé, où w vaut de 20 à 80, x vaut de 10 à 50, y vaut de 10 à 50, z vaut de 10 à 50, de sorte que la somme de toutes les concentrations (w + x + y + z + χ) est égale à 100, où χ représente une somme totale d'impuretés en pourcentage atomique et dans lequel Y représente un ou plusieurs éléments choisis dans le groupe constitué de B, Al, Ga, In et Tl.

2. Dispositif photoélectrique selon la revendication 1 dans lequel ladite couche de couverture contenant de l'azote comprend de l'azote, du zinc, de l'oxygène et du gallium.

3. Dispositif photoélectrique selon la revendication 1 dans lequel Y est Ga.

4. Dispositif photoélectrique selon la revendication 1 où χ vaut 10 pour cent atomique ou moins.

5. Composition de couverture TCO contenant de l'azote pour recouvrir une couche d'oxyde conductrice transparente d'oxyde de zinc dopé (200, 201), constituée de Zn_{w}OₓN_{y}Y_{z}, où w, x, y, z sont des pourcentages atomiques de zinc, d'oxygène, d'azote et de Y dans la composition, où w vaut de 20 à 80, x vaut de 10 à 50, y vaut de 10 à 50, z vaut de 10 à 50, de sorte que la somme de toutes les concentrations (w + x + y + z + χ) est égale à 100, où χ représente une somme totale d'impuretés en pourcentage atomique et dans laquelle Y représente un ou plusieurs éléments choisis dans le groupe constitué de B, Al, Ga, In, Tl, Sn, W, Ta, Nb, F, Cl, Br, I et At.

6. Composition de couverture TCO contenant de l'azote selon la revendication 5 dans laquelle Y représente un ou plusieurs éléments choisis dans le groupe constitué de B, Al, Ga, In, Tl.

7. Composition de couverture TCO contenant de l'azote selon la revendication 5 dans laquelle Y est Ga.

8. Composition de couverture TCO contenant de l'azote selon la revendication 5 où χ vaut 10 pour cent atomique ou moins.

9. Composition de couverture TCO contenant de l'azote selon la revendication 5 qui est un film ou une couche.

10. Diode électroluminescente organique comprenant une électrode, dans laquelle ladite électrode comprend la composition de couverture TCO contenant de l'azote selon la revendication 5.

11. Écran tactile comprenant une électrode, dans lequel ladite électrode comprend la composition de couverture TCO contenant de l'azote selon la revendication 5.

12. Dispositif d'affichage comprenant une électrode, dans lequel ladite électrode comprend la composition de couverture TCO contenant de l'azote selon la revendication 5.
